**Europäisches Patentamt**

**European Patent Office**

**Office européen des brevets**

(11) Veröffentlichungsnummer : **0 148 342**
**B1**

(12) **EUROPÄISCHE PATENTSCHRIFT**

(45) Veröffentlichungstag der Patentschrift :
**27.07.88**

(21) Anmeldenummer : **84112821.8**

(22) Anmeldetag : **24.10.84**

(51) Int. Cl.⁴ : **H 01 L 21/82, H 01 L 27/08, H 01 L 29/08**

(54) **Verfahren zum gleichzeitigen Herstellen von schnellen Kurzkanal- und spannungsfesten MOS-Transistoren in VLSI-Schaltungen.**

(30) Priorität : **09.11.83 DE 3340560**

(43) Veröffentlichungstag der Anmeldung :
**17.07.85 Patentblatt 85/29**

(45) Bekanntmachung des Hinweises auf die Patenterteilung : **27.07.88 Patentblatt 88/30**

(84) Benannte Vertragsstaaten :
**AT DE FR GB IT NL SE**

(56) Entgegenhaltungen :
**EP-A- 0 054 117**
**EP-A- 0 081 804**
**DE-A- 2 740 549**
**US-A- 4 334 235**
**US-A- 4 385 947**
**MICROELECTRONICS JOURNAL, Band 13, Nr. 6, November, Dezember 1982, Seiten 29-32, KIRKCALDY, (GB). T. QIN YI et al.: "A CMOS process for VLSI instrumentation".**

(73) Patentinhaber : **Siemens Aktiengesellschaft Berlin und München**
**Wittelsbacherplatz 2**
**D-8000 München 2 (DE)**

(72) Erfinder : **Schwabe, Ulrich, Dr. phil.**
**Plievierpark 14**
**D-8000 München 83 (DE)**
Erfinder : **Werner, Christoph, Dr. rer. nat.**
**Pentenriederstrasse 15**
**D-8033 Krailling (DE)**

## Beschreibung

Die Patentanmeldung betrifft ein Verfahren zum gleichzeitigen Herstellen von schnellen Kurzkanal (Typ A)- und spannungsfesten MOS-Transistoren (Typ B), wie sie in VLSI (= Very Large Scale Integration) Schaltungen, bei denen digitale und analoge Funktionen auf einem Chip integriert werden, verwendet werden, bei dem für die Aufnahme der n- bzw. p-Kanaltransistoren der Schaltung im Siliziumsubstrat p- bzw. n-dotierte Wannen erzeugt werden, in welche zur Einstellung der verschiedenen Transistoreinsatzspannungen die entsprechenden Dotierstoffatome durch mehrfache Ionenimplantation eingebracht werden, wobei die Maskierung für die einzelnen Ionen-Implantationen durch Fotolack- und/oder durch Siliziumoxid- bzw. Siliziumnitrid-Strukturen erfolgt und bei dem die Herstellung der Source/Drain- und Gate-Bereiche sowie die Erzeugung des Zwischen- und Isolationsoxids und der Leiterbahnebene nach bekannten Verfahrensschritten der MOS-Technologie vorgenommen wird.

Für moderne VLSI-Schaltungen, bei denen digitale und analoge Funktionen auf einem Chip integriert werden sollen, benötigt man zwei Sorten von MOS-Transistoren :

Typ A : Kurzkanaltransistoren, die sehr hohe Schaltgeschwindigkeiten ermöglichen sollen, jedoch keine höheren Spannungen als die Versorgungsspannung ($V_{DD}$ = 5 V) aushalten müssen ;

Typ B : Analogtransistoren, an denen höhere Drainspannungen auftreten können (bis $V_{DD}$ = 12 V), an deren Schaltgeschwindigkeit jedoch keine so hohen Anforderungen gestellt werden.

Aufgabe der vorliegenden Erfindung ist es, beide Transistortypen mit möglichst wenigen zusätzlichen Prozeßschritten gleichzeitig herzustellen.

Aus dem Konferenzband der International Solid-State-Circuits-Conference, Februar 1983, auf Seite 90/91 ist aus einem Aufsatz von R. A. Haken et al bekannt, denjenigen n-Kanal-Transistoren, die höheren Spannungen ausgesetzt sein können, eine zusätzliche niedrig dotierte Anschlußdiffusion an den Source/Drain-Gebieten zu geben (lightly doped drains).

Die Erfindung beschreitet einen anderen Weg und löst die gestellte Aufgabe bei einem Verfahren der eingangs genannten Art durch den Ablauf folgender Verfahrensschritte :

a) Aufbringen einer ersten aus Siliziumoxid und Siliziumnitrid bestehenden Doppelschicht auf p-dotiertes Siliziumsubstrat ;

b) Herstellung der n-Wannen durch eine Phosphor-, Arsen- oder Antimon-Ionenimplantation nach erfolgter Maskierung der übrigen Bereiche mit einer Fotolackschicht und nach Entfernung der Siliziumnitridschicht im n-Wannenbereich ;

c) Ablösen der Fotolackmaske ;

d) Durchführung eines lokalen Oxidationsprozesses zur Erzeugung eines Maskieroxids für die nachfolgende Bor-Tiefimplantation außerhalb des n-Wannenbereiches und erster Eindiffusionsschritt der Phosphor-, Arsen- oder Antimon-Ionen ;

e) Ablösen der Siliziumnitridstrukturen und weiteres Eintreiben der n-Wanne ;

f) Durchführung einer ersten Bor-Ionenimplantation ;

g) Ganzflächiges Ablösen der Oxidmaskierung ;

h) Aufbringen einer zweiten, aus Siliziumoxid und Siliziumnitrid bestehenden Doppelschicht auf die Substratoberfläche und Strukturierung der mit einer Fotolackmaske bedeckten Siliziumnitridschicht so, daß die aktiven Transistorbereiche von der Siliziumnitridschicht bedeckt bleiben ;

i) Ablösen der Fotolackmaske ;

j) Aufbringen einer weiteren Fotolackschicht über den n-Wannenbereichen ;

k) Durchführung einer zweiten Bor-Ionenimplantation zur Erzeugung der n-Kanal-feldimplantierten Bereiche ;

l) Ablösen der Fotolackstrukturen ;

m) Erzeugen der Feldoxidbereiche mittels lokaler Oxidation unter Verwendung der Siliziumnitridschicht als Maskierung ;

n) Entfernen der Siliziumnitridschicht und der darunterliegenden Oxidschicht und Durchführung eines Oxidationsprozesses zur Herstellung des Gateoxids ;

o) Durchführung einer dritten ganzflächigen Bor-Ionenimplantation zur Dotierung des n- und p-Kanals, wobei die Implantationsdosis in Abstimmung mit den anderen Implantationen so gewählt wird, daß für den n- und den p-Kanal-Transistor eine möglichst symmetrische Einsatzspannung $|U_T|$ erreicht wird ;

p) Abscheidung und Strukturierung von Polysilizium zur Bildung der Gatebereiche ;

q) Durchführung eines Oxidationsprozesses so, daß die Oxidschicht die nachfolgende Source/Drain-Implantationen der p-Kanal- und der n-Kanal-Transistoren nicht maskiert, im Bereich der Polysiliziumkante jedoch maskierend wirken kann ;

r) Aufbringen einer aus Fotolack bestehenden Maskierung auf die p-Kanal-Transistorbereiche, die n-Kanal-Transistoren und die Source-Gebiete sowie die Feldoxidkante der Draingebiete der n-Kanal-Transistoren vom Typ B ;

s) Durchführung einer Phosphor-Ionen-Implantation im Draingebiet des n-Kanal-Transistorbereiches ;

t) Eindiffusion der Phosphor-Ionen nach Ablösen der Fotolackmaske ;

u) Durchführung einer weiteren Phosphor-Ionen-Implantation zur Erzeugung der Source/Drain-Bereiche der n-Kanal-Transistoren des Typ A und des Typ B nach Maskierung der n-Wassenbereiche mit Fotolack ;

v) Durchführung einer Fotolacktechnik zur

Maskierung des n-Kanal-Transistorbereiches ;

w) Durchführung einer vierten Bor-Ionenimplantation zur Erzeugung der Source/Drain-Bereiche der p-Kanal-Transistoren ;

x) Entfernung der Fotolackmaskierung und

y) Erzeugung der Isolationsschicht, der Kontaktlochbereiche und der Metall-Leiterbahnebene in bekannter Weise.

Das Verfahren nach der Lehre der Erfindung, welches bis auf die doppelte Phosphor-Ionen-Implantation nach Verfahrensschritt s) und u) nach erfolgter Fotolackmaskierung nach Verfahrensschritt q) und den Diffusionsprozeß nach Verfahrensschritt t) gleich verläuft wie in der am 31. Oktober 1984 veröffentlichten EP-A-0 123 182 vorgeschlagen, erfordert nur eine zusätzliche Maske (Verfahrensschritt q)), die jedoch unkritisch ist, weil sie nur die von der tiefen Drain-Implantation auszunehmenden Source-Bereiche und die Drain-Bereiche der digitalen Schaltungsteile abdecken muß. Im Gegensatz zur bekannten Lösung erfolgt die Implantation selbst selbstjustierend durch das gleiche Fenster wie die nachfolgende eigentliche Source/Drain-Implantation auch.

Das Verfahren nach der Lehre der Erfindung läßt sich sowohl für NMOS-, wie auch für CMOS-Schaltungen anwenden, wobei es sich bei CMOS-Schaltungen um einen N-Wannen- als auch um einen P-Wannen-Prozeß handeln kann.

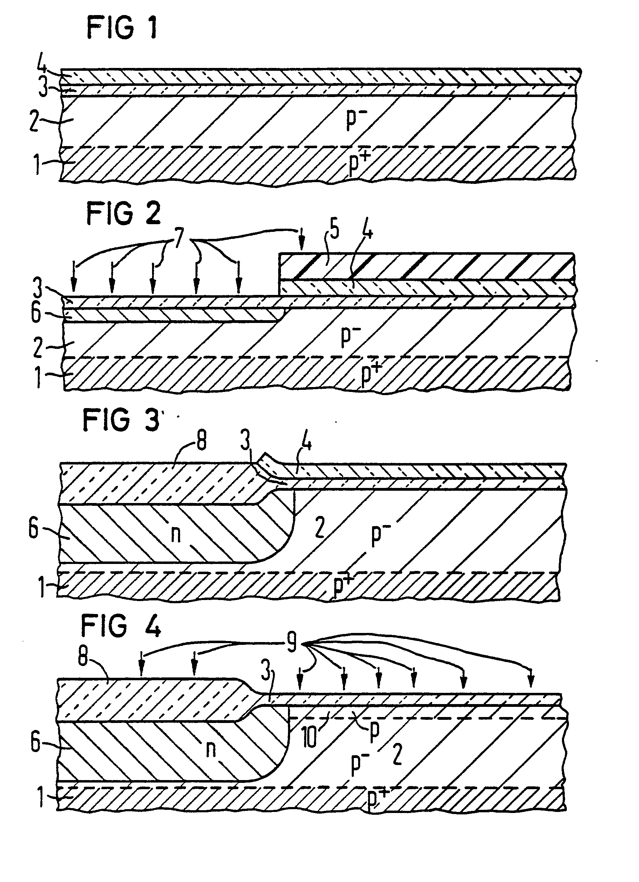

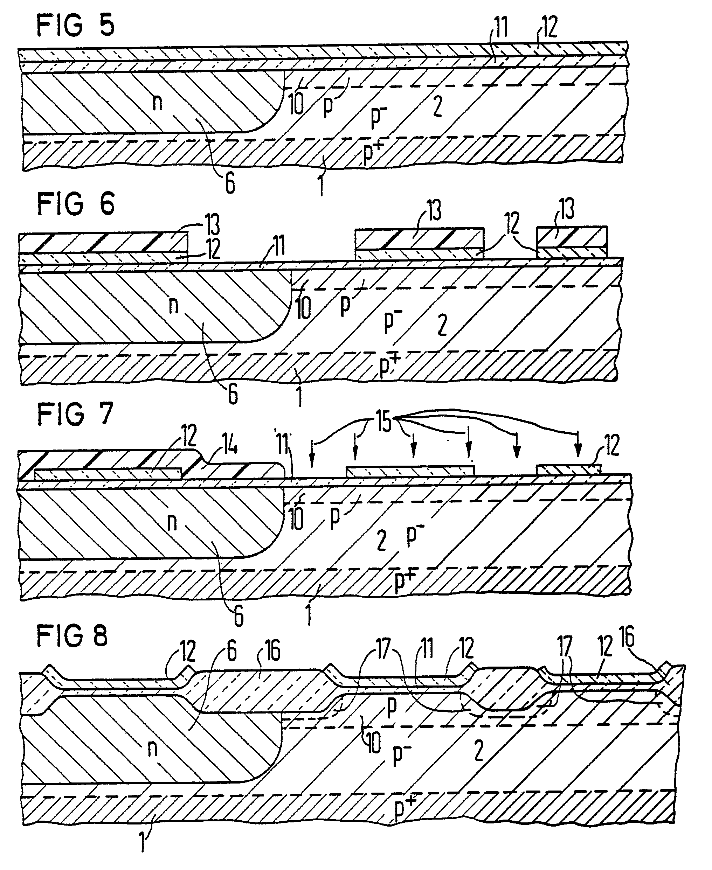

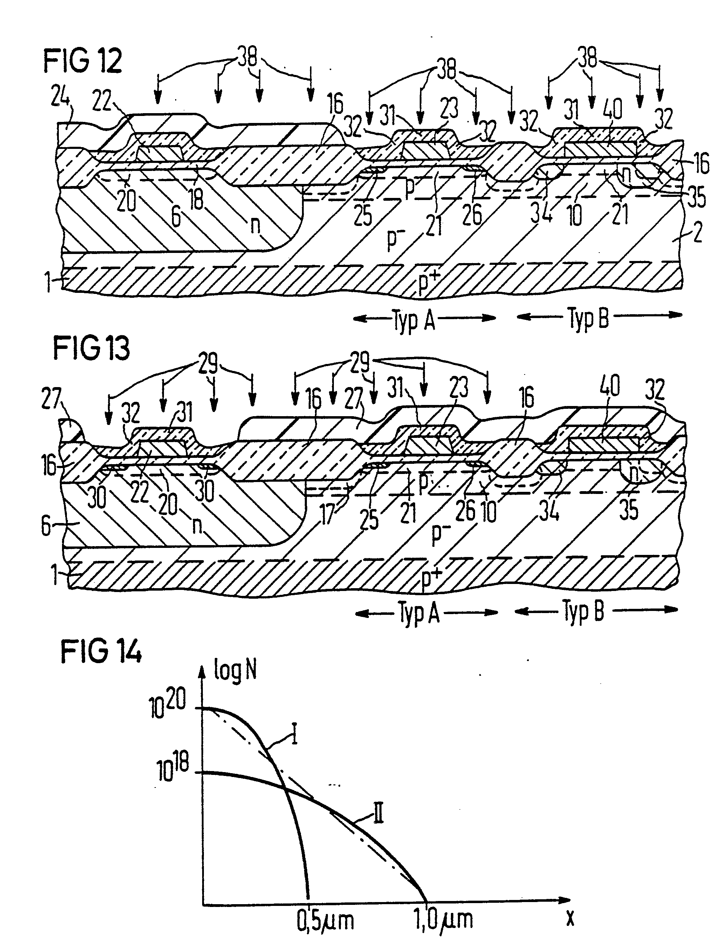

Weitere Ausgestaltungen der Erfindung ergeben sich aus den Unteransprüchen, sowie aus der Beschreibung eines Ausführungsbeispiels anhand der Figuren 1 bis 13, welche im Schnittbild die erfindungswesentlichen Verfahrensschritte für einen CMOS-N-Wannen-Prozeß mit zusätzlichen Analog-Transistoren darstellen. Die Figur 14 zeigt in einem Diagramm das Dotierungsprofil im Drain-Bereich des Typ B-Transistors. In allen Figuren gelten für gleiche Teile gleiche Bezugszeichen.

Figur 1 : Zu Beginn der Prozeßfolge wird auf ein, mit einer $p^-$-dotierten Epitaxieschicht 2 (6 bis 10 μm Dicke, 20 Ohm · cm) versehenes $p^+$-dotiertes in [100]-Richtung orientiertes Siliziumsubstrat 1 (0,01 bis 0,02 Ohm · cm) eine aus einer $SiO_2$-Schicht 3 (50 nm) und einer Siliziumnitridschicht 4 (140 nm) bestehende Doppelschicht abgeschieden.

Figur 2 : Mit Hilfe einer Fotolackstruktur 5 wird die Siliziumnitridschicht 4 strukturiert und die n-Wanne 6 durch eine Phosphorionenimplantation 7 mit einer Dosis und Energie von 2 bis $2,5 \times 10^{12}$ cm$^{-2}$ bzw. 160 keV erzeugt.

Figur 3 : Nach Ablösen der Fotolackstruktur (5) wird ein lokaler Oxidationsprozeß zur Erzeugung eines Maskieroxids 8 (500 nm) für die nachfolgende Bor-Tiefimplantation (9) durchgeführt und dabei die Phosphor-Ionen (7) in den n-Wannenbereich 6 ein diffundiert.

Figur 4 : Nach Ablösen der Siliziumnitridstruktur (4) wird ein weiterer Eindiffusionsschritt der n-Wanne (drive-in ~ 2 bis 6 μm) und die Bor-Tiefimplantation (siehe Pfeile 9) mit einer Dosis und Energie von 3 bis $7 \times 10^{11}$ cm$^{-2}$ bzw. 60 Kev

durch die lokale Oxidmaske 8 selbstjustierend zur n-Wanne 6 durchgeführt. Es entsteht die p-dotierte Zone 10.

Figur 5 : Nach Entfernung der Oxidmaskierung (8) wird eine weitere, aus Siliziumoxid 11 und Siliziumnitrid 12 bestehende Doppelschicht auf die Substratoberfläche (1, 2, 6, 10) aufgebracht.

Figur 6 : Mit einer Fotolackmaske 13 wird die Siliziumnitridschicht 12 so strukturiert, daß sie die aktiven Transportbereiche im Substrat überdeckt.

Figur 7 : Nach Ablösen der Fotolackmaske 13 wird eine weitere Fotolackstruktur 14 zur Maskierung der n-Wanne 6 erzeugt und die n-Kanal-Feldimplantation (siehe Pfeile 15) mit Bor-Ionen bei einer Dosis und Energie von 1 bis $2 \times 10^{13}$ cm$^{-2}$ und 25 keV durchgeführt.

Figur 8 : Nach Ablösung der Fotolackstruktur 14 werden dann unter Verwendung der Siliziumnitridschicht 12 als Maskierung die Feldoxidbereiche 16 in einer Schichtdicke von 800 bis 1 000 nm durch lokale Oxidation erzeugt. Dabei entstehen die p-dotierten Zonen 17.

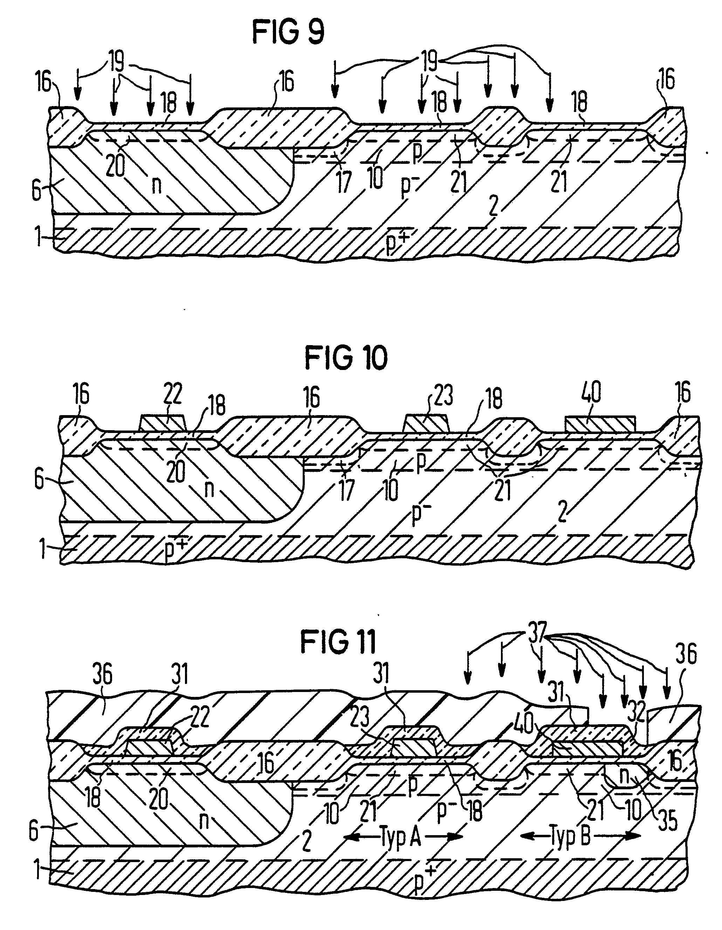

Figur 9 : Nach Ablösen der Siliziumnitridschicht 12 und der Siliziumoxidschicht 11 erfolgt eine thermische Oxidation der gesamten Oberfläche, wobei die Dicke der Gateoxidschicht 18 mit 15 bis 50 nm eingestellt wird. Dann erfolgt eine ganzflächige flache Bor-Ionenimplantation (siehe Pfeile 19) zur Dotierung des p- und n-Kanals (20, 21), wobei die Implantationsdosis in Abstimmung mit den anderen Implantationen so gewählt wird, daß für den n- und den p-Kanal eine möglichst symmetrische Einsatzspannung $U_T$ erreicht wird. Im vorliegenden Ausführungsbeispiel wird die Implantationsdosis und Energie auf $4,5 \times 10^{11}$ B$^+$ cm$^{-2}$ bzw. 25 keV eingestellt, was einer Einsatzspannung $|U_T| = 0,8$ V entspricht. Da die Ionenimplantation (19) ganzflächig erfolgt, wird im Gegensatz zu bekannten CMOS-Prozessen keine Maske benötigt.

Figur 10 : Es erfolgt nun die Abscheidung der Polysiliziumebene (500 nm) und ihre Strukturierung, wobei die Gateelektroden 22, 23 und 40 gebildet werden.

Figur 11 : Nach Durchführung eines Oxidationsprozesses, wobei die entstehende Oxidschicht 31 im n-Wannenbereich 6 nach erfolgter Source/Drain-Implantation der p-Kanaltransistoren nicht maskiert, im Bereich der Polysiliziumkante jedoch maskierend wirken kann, wird eine aus Fotolack bestehende Maskierung 36 auf die p-Kanaltransistorbereiche (6, 18, 20, 22), auf die n-Kanaltransistoren (10, 18, 21, 23) vom Typ A und das Source-Gebiet (34) sowie auf die Feldoxidkante des Draingebietes (35) der n-Kanaltransistoren vom Typ B aufgebracht und die durch die Pfeile 37 gekennzeichnete erste (erfindungsgemäße) Phosphor-Ionen-Implantation mit einer Energie und Dosis von $1 \times 10^{14}$ cm$^{-2}$ und 80 keV im Draingebiet 35 des Typ B-Transistor durchgeführt. Die Oxidschicht 32 auf den Flanken des Poly-Si-Gates der n-Kanaltransistoren dient dabei zur Zurückziehung der Implantationskante (S/D pull back). Durch Eindiffusion der Phosphor-Ionen 37 (Drive-In-Schritt) bei 1 000 °C in etwa 3 Stunden nach Ablösung der Maske 36 entsteht die Drainzone 35 des Typ B-Transistors.

Figur 12 : Nun wird nach Maskierung der n-Wannenbereiche 6 mit einer Fotolackmaske 24 die eigentliche Phosphor-Ionenimplantation 38 zur Erzeugung der Source/Drain-Bereiche der n-Kanaltransistoren des Typ A und des Typ B (34, 35) durchgeführt. Die Oxidschicht 32 auf den Flanken des Poly-Si-Gates der n-Kanaltransistoren dient dabei zur Zurückziehung der Implantationskante (S/D pull back). Dabei wird die Dosis und Energie auf $3 \times 10^{15}$ cm$^{-2}$ und 90 keV eingestellt.

Figur 13 : Nach Ablösung der Fotolackmaske 24 wird erneut eine Fotolackmaske 27 zur Maskierung des n-Kanal-Transistorbereiches aufgebracht und die ganzflächige Bor-Ionenimplantation (siehe Pfeile 29) zur Erzeugung der Source/Drain-Zonen 30 der p-Kanal-Transistoren in der n-Wanne 6 durchgeführt. Dabei werden Dosis und Energie auf $4 \times 10^{15}$ cm$^{-2}$, 25 keV eingestellt. Die Oxidschicht 32 auf den Flanken des Poly-Si-Gates der p-Kanal-Transistoren dient dabei zur Zurückziehung der Implantation (S/D-pull back). Nach Ablösung der Fotolackmaske 27 entstehen durch Eintreiben der implantierten Boratome die Source/Drain-Bereiche 30 der p-Kanaltransistoren.

Die Erzeugung der Isolationsschicht, der Kontaktlochbereiche und der Metall-Leiterbahnebene erfolgt nach bekannten Verfahrensschritten der CMOS-Technologie und wird nicht dargestellt.

Figur 14 : Zeigt das Dotierungsprofil im Drainbereich des Typ B-Transistors. Dabei ist als Abszisse die Eindringtiefe x der Dotierungsatome im Substrat und als Ordinate die Dotierungskonzentration in logarithmischen Maßstab (log N) aufgetragen. Die Kurve I entspricht der eigentlichen S/D-Implantation nach Verfahrensschritt u) und die Kurve II der im Rahmen der Erfindung durchgeführten zusätzlichen Implantation nach Verfahrensschritt s) und t). Die zusätzliche Implantation und die Drive-In-Diffusion sind so zu wählen, daß der Feldverlauf vor dem drainseitigen pn-Übergang möglichst weich ist. Dieses Ziel wird optimal dann erreicht, wenn der Dotierungsabfall im logarithmischen Maßstab linear von der Polysiliziumkante in den Kanal hinein abnimmt, da dieser Verlauf bei gegebener Unterdiffusion $x_{js}$ den kleinsten logarithmischen Dotierungsgradienten d (log N)/dx aufweist. Dieser Verlauf (siehe strichpunktierte Linie) läßt sich dadurch erreichen, daß erfindungsgemäß die zusätzliche Implantation nach Verfahrenschritt s) und die eigentliche S/D-Implantation nach Verfahrensschritt u) beide mit Phosphor ausgeführt werden, wobei die Dosis der zusätzlichen Implantation ein bis zwei Größenordnungen unter der Dosis der eigentlichen Implantation liegt und die Eindringtiefe x bei der zusätzlichen Drive-In-Diffusion nach Verfahrensschritt t) etwa doppelt so groß wie die Eindringtiefe der eigentlichen S/D-Gebiete gewählt wird.

**Patentansprüche**

1. Verfahren zur gleichzeitigen Herstellen von schnellen Kurzkanal (Typ A)- und spannungsfesten MOS-Transistoren (Typ B), wie sie in VLSI (= Very Large Scale Integration)-Schaltungen, bei denen digitale und analoge Funktionen auf einem Chip integriert werden, verwendet werden, bei dem für die Aufnahme der n- bzw. p-Kanaltransistoren der Schaltung im Siliziumsubstrat (1, 2) p- bzw. n-dotierte Wannen (10, 6) erzeugt werden, in welche zur Einstellung der verschiedenen Transistoreinsatzspannungen die entsprechenden Dotierstoffatome durch mehrfache Ionenimplantation eingebracht werden, wobei die Maskierung für die einzelnen Ionen-Implantationen durch Fotolack- und/oder durch Siliziumoxid- bzw. Siliziumnitrid-Strukturen erfolgt und bei dem die Herstellung der Source/Drain (26, 30, 34, 35)- und Gate-Bereiche (22, 23, 40) sowie die Erzeugung des Zwischen- und Isolationsoxids und der Leiterbahnebene nach bekannten Verfahrensschritten der MOS-Technologie vorgenommen wird, wobei das Verfahren den Ablauf folgender Verfahrensschritte aufweist :

a) Aufbringen einer ersten aus Siliziumoxid (3) und Siliziumnitrid (4) bestehenden Doppelschicht auf p-dotiertes Siliziumsubstrat (1, 2) ;

b) Herstellung der n-Wannen (6) durch eine Phosphor-, Arsen- oder Antimon-Ionenimplantation (7) nach erfolgter Maskierung der übrigen Bereiche mit einer Fotolackschicht (5) und nach Entfernung der Siliziumnitridschicht (4) im n-Wannenbereich (6) ;

c) Ablösen der Fotolackmaske (5) ;

d) Durchführung eines lokalen Oxidationsprozesses zur Erzeugung eines Maskieroxids (8) für die nachfolgende Bor-Tiefimplantation (9) außerhalb des n-Wannenbereiches (6) und erster Eindiffusionsschritt der Phosphor-, Arsen oder Antimon-Ionen (7) ;

e) Ablösen der Siliziumnitridstrukturen (4) und weiteres Eintreiben der n-Wanne (6) ;

f) Durchführung einer ersten Bor-Ionenimplantation (9) ;

g) Ganzflächiges Ablösen der Oxidmaskierung (3, 8) ;

h) Aufbringen einer zweiten, aus Siliziumoxid (11) und Siliziumnitrid (12) bestehenden Doppelschicht auf die Substratoberfläche und Strukturierung der mit einer Fotolackmaske (13) bedeckten Siliziumnitridschicht (12) so, daß die aktiven Transistorbereiche von der Siliziumnitridschicht (12) bedeckt bleiben ;

i) Ablösen der Fotolackmaske (13) ;

j) Aufbringen einer weiteren Fotolackschicht (14) über den n-Wannenbereichen (6) ;

k) Durchführung einer zweiten Bor-Ionenimplantation (15) zur Erzeugung der n-Kanal-feldimplantierten Bereiche (17) ;

l) Ablösen der Fotolackstrukturen (14) ;

m) Erzeugen der Feldoxidbereiche (16) mittels lokaler Oxidation unter Verwendung der Siliziumnitridschicht (12) als Maskierung ;

n) Entfernen der Siliziumnitridschicht (12) und der . darunterliegenden Oxidschicht (11) und Durchführung eines Oxidationsprozesses zur Herstellung des Gateoxids (18) ;

o) Durchführung einer dritten ganzflächigen Bor-Ionenimplantation (19) zur Dotierung des n- (21) und p-Kanals (20), wobei die Implantationsdosis in Abstimmung mit den anderen Implantationen so gewählt wird, daß für den n- und den p-Kanal-Transistor eine möglichst symmetrische Einsatzspannung |U_T|erreicht wird ;

p) Abscheidung und Strukturierung von Polysilizium zur Bildung der Gatebereiche (22, 23, 40) ;

q) Durchführung eines Oxidationsprozesses so, daß die Oxidschicht (31) die nachfolgende Source/-Drain-Implantationen (29, 38) der p-Kanal- und der n-Kanal-Transistoren nicht maskiert, im Bereich der Polysiliziumkante jedoch maskierend wirken kann ;

r) Aufbringen einer aus Fotolack bestehenden Maskierung (36) auf die p-Kanal-Transistorbereiche (6, 18, 20, 22), die n-Kanal-Transistoren (10, 18, 21, 23) und die Source-Gebiete (34) sowie die Feldoxidkante der Draingebiete (35) der n-Kanal-Transistoren vom Typ B ;

s) Durchführung einer Phosphor-Ionen-Implantation (37) im Draingebiet (35) des n-Kanal-Transistorbereiches (21) ;

t) Eindiffusion der Phosphor-Ionen (37) nach Ablösen der Fotolackmaske (36) ;

u) Durchführung einer weiteren Phosphor-Ionen-Implantation (38) zur Erzeugung der Source/Drain-Bereiche (25, 26, 34, 35) der n-Kanal-'Transistoren des Typ A (25, 26) und des Typ B (34, 35) nach Maskierung der n-Wannenbereiche (6) mit Fotolack (24) ;

v) Durchführung einer Fotolacktechnik zur Maskierung (27) des n-Kanal-Transistorbereiches ;

w) Durchführung einer vierten Bor-Ionenimplantation (29) zur Erzeugung der Source/Drain-Bereiche (30) der p-Kanal-Transistoren ;

x) Entfernung der Fotolackmaskierung (27) und

y) Erzeugung der Isolationsschicht, der Kontaktlochbereiche und der Metall-Leiterbahnebene in bekannter Weise.

2. Verfahren nach Anspruch 1, dadurch gekennzeichnet, daß die Dosis und Energie der ersten Phosphor-Ionen-Implantation (37) nach Verfahrensschritt s) auf $5 \times 10^{13} - 1 \times 10^{15}$ cm$^{-2}$ und 80 keV und die der zweiten Phosphor-Ionen-Implantation (38) nach Verfahrensschritt u) auf $3 \times 10^{15} - 3 \times 10^{16}$ cm$^{-2}$ und 80 keV eingestellt wird.

3. Verfahren nach Anspruch 1 und 2, dadurch gekennzeichnet, daß die Eindiffusion der Phosphor-Ionen nach Verfahrensschritt t) im Bereich von 1 000 ºC während einer Zeitdauer von 1 — 5 Stunden vorgenommen wird.

4. Integrierte, digitale und analoge Funktionen enthaltende MOS-Transistorschaltung in VLSI-Technik, gekennzeichnet durch einen, durch unterschiedlich implantierte Phosphor-Ionen erzeugten Dotierungsabfall am drainseitigen pn- Übergang der Analogtransistoren, der im logarithmischen Maßstab linear von der die Gate-Elektrode bildenden Polysiliziumkante in den Kanalbereich hinein abnimmt (Figur 14).

**Claims**

1. A process for the simultaneous production of high-speed short-channel transistors (Type A) and voltage-stable MOS-transistors (Type B), such as are used in VLSI (Very Large Scale Integration)-circuits, in which digital and analogue functions are integrated on one chip, wherein, for the accommodation of the n- and p-channel transistors of the circuit, p- and n-doped troughs (10, 6) are formed in the silicon substrate into which the appropriate dopant atoms are introduced by multiple ion implantation in order to set the various transistor start voltages, the masking for the individual ion implantation steps being carried out using photo-resist and/or silicon oxide or silicon nitride structures, and wherein the formation of the source/drain zones (26, 30, 34, 35) and gate zones (22, 23, 40) and the formation of the intermediate oxide and insulating oxide layers and of the conductor path level is carried out by process steps known in MOS-technology, the process comprising the sequence of the following process steps :

a) application of a first double layer made of silicon oxide (3) and silicon nitride (4) to a p-doped silicon substrate (1, 2) ;

b) formation of the n-troughs (6) by a phosphorus, arsenic, or antimony ion implantation (7) after masking of the other zones with a photo-resist layer (5) and after the removal of the silicon nitride layer (4) in the n-trough zone (6) ;

c) removal of the photo-resist mask (5) ;

d) carrying out of a local oxidation process to form a masking oxide layer (8) for the following deep boron implantation (9), outside the n-trough zone (6) and of a first diffusing-in of the phosphorus, arsenic, or antimony ions (7) ;

e) removal of the silicon nitride structures (4) and further driving-in of the n-trough (6) ;

f) carrying out of a first boron ion implantation (9) ;

g) removal of the oxide mask (3, 8) from the entire surface ;

h) application of a second double layer of silicon oxide (11) and silicon nitride (12), to the substrate surface and structuring of the silicon nitride layer (12), covered by a photo-resist mask (13), in such manner that the active transistor zones remain covered by the silicon nitride layer (12) ;

i) removal of the photo-resist mask (13) ;

j) application of a further photo-resist layer (14) over the n-trough zones (6) ;

k) carrying out a second boron ion implantation (15) to form the n-channel-field-implanted zones (17) ;

l) removal of the photo-resist structures (14) ;

m) formation of the field oxide zones (16) by local oxidation using the silicon nitride layer (12) as mask ;

n) removal of the silicon nitride layer (12) and of the underlying oxide layer (11) and carrying out of an oxidation process to form the gate oxide layer (18) ;

o) carrying out of a third boron ion implantation (19) into the entire surface to dope the n-channel (21) and p-channel (20), the implantation dose being so selected, in conformity with the other implantations, that a start voltage $|U_T|$ which is as symmetrical as possible is achieved for the n-channel and p-channel transistors ;

p) deposition and structuring of polysilicon to form the gate regions (22, 23, 40) ;

q) carrying out of an oxidation process in such manner that the oxide layer (31) does not mask the following source/drain implantations (29, 38) of the p-channel and n-channel transistors, but can act as a mask in the region of the polysilicon edge ;

r) application of a photo-resist mask (36) to the p-channel transistor zones (6, 18, 20, 22), to the n-channel transistors (10, 18, 21, 23) and the source zones (34), and to the field oxide edge of the drain zones (5) of the n-channel transistors of Type B ;

s) carrying out of a phosphorus ion implantation (37) in the drain zone (35) of the n-channel transistor zone (21) ;

t) diffusing-in of the phosphorus ions (37) following the removal of the photo-resist mask (36) ;

u) carrying out of a further phosphorus ion implantation (38) to form the source/drain zones (25, 26, 34, 35) of the n-channel transistors of Type A (25, 26) and of Type B (34, 35) after photoresist masking (24) of the n-trough zones (6) ;

v) carrying out of a photo-resist step for masking (27) the n-channel transistor zones ;

w) carrying out of a fourth boron ion implantation (29) to form the source/drain zones (30) of the p-channel transistors ;

x) removal of the photo-resist mask (27), and

y) formation of the insulating layer, the contact hole regions and the metal conductor path level in known manner.

2. A process as claimed in Claim 1, characterised in that the dose and energy of the first phosphorus ion implantation (37) in accordance with process step s) is set at $5 \times 10^{13} - 1 \times 10^{15}$ cm$^{-2}$ and 80 keV, and in the second phosphorus ion implantation (38) in accordance with process step u) at $3 \times 10^{15} - 3 \times 10^{16}$ cm$^{-2}$ and 80 keV.

3. A process as claimed in Claim 1 and 2, characterised in that the diffusing-in of the phosphorus ions in accordance with process step t) is carried out in the region of 1 000 °C for a time of 1 — 5 hours.

4. An integrated MOS-transistor circuit, which includes digital and analogue functions, in VLSI-technology, characterised by a doping gradient produced by differently implanted phosphorus ions at the drain-side pn-junction of the analogue transistors, which, on the logarithmic scale, decreases linearly from the edge of the polysilicon which forms the gate electrode to the channel zone (Fig. 14).

## Revendications

1. Procédé pour fabriquer simultanément des transistors MOS rapides à canal court (type A) et des transistors MOS résistant à la tension (type B), du type utilisés dans des circuits à très haute densité d'intégration VLSI (= Very Large Scale Integration), pour lesquels des fonctions numériques et analogiques sont intégrées sur une microplaquette, et selon lequel, pour la mise en place des transistors à canal n ou p du circuit, on aménage, dans le substrat en silicium (1, 2), des cuvettes (10, 6) dopées du type p et du type n et dans lesquelles, pour régler les différentes tensions de service des transistors, on insère les atomes correspondants de substance dopante au moyen d'une implantation ionique multiple, auquel cas le masquage pour les différentes implantations ioniques s'effectue au moyen de structures en laque photosensible et/ou de structures de bioxyde de silicium ou de nitrure de silicium et selon lequel la fabrication des régions de source/drain (26, 34, 35) et des régions de grille (22, 23, 40) ainsi que la production de l'oxyde intermédiaire et de l'oxyde isolant et du plan des voies conductrices est réalisée selon des étapes opératoires connues de la technologie MOS, le procédé incluant l'exécution des étapes opératoires suivantes :

a) dépôt d'une première couche double constituée par de l'oxyde de silicium (3) et du nitrure de silicium (4) sur un substrat en silicium (1, 2) dopé du type p ;

b) fabrication des cuvettes (6) de type n au moyen d'une implantation (7) d'ions de phosphore, d'arsenic ou d'antimoine après masquage des autres zones au moyen d'une couche de laque photosensible (5), après élimination de la couche de nitrure de silicium (4) dans la zone (6) des cuvettes de type n ;

c) dissolution du masque de laque photosensible (5) ;

d) mise en œuvre d'un procédé d'oxydation locale pour la production d'un oxyde de masquage (8) pour l'implantation profonde ultérieure de bore (9), à l'extérieur de la région (6) des cuvettes de type n et mise en œuvre de la première étape de diffusion des ions (7) de phosphore, d'arsenic ou d'antimoine ;

e) dissolution des structures de nitrure de silicium (4) et enfoncement supplémentaire de la cuvette (6) de type n ;

f) mise en œuvre d'une première implantation (9) d'ions de bore ;

g) dissolution du masque d'oxyde (3, 8) sur l'ensemble de la surface ;

h) dépôt d'une seconde couche double constituée par de l'oxyde de silicium (11) et du nitrure de silicium (12) sur la surface du substrat et structuration de la couche de nitrure de silicium (12) recouverte d'un masque de laque photosensible (13) de telle sorte que les régions actives des transistors restent recouvertes par la couche de nitrure de silicium (12) ;

i) dissolution du masque de laque photosensible (13) ;

j) dépôt d'une autre couche de laque photosensible (14) sur les régions (6) des cuvettes de type n ;

k) exécution d'une seconde implantation d'ions de bore (15) pour la production des régions (17) ayant subi une implantation de champ à canal n ;

l) dissolution des structures de laque photosensible (14) ;

m) production des régions d'oxyde de champ (16) à l'aide d'une oxydation locale moyennant l'utilisation de la couche de nitrure de silicium (12) en tant que masque ;

n) élimination de la couche de nitrure de silicium (12) et de la couche d'oxyde sous-jacente (11) et mise en œuvre d'un processus d'oxydation pour fabriquer l'oxyde de grille (18) ;

o) mise en œuvre d'une troisième implantation (19) d'ions de bore sur toute la surface pour réaliser le dopage du canal de type n (21) et du canal de type p (20), la dose d'implantation étant choisie en accord avec les autres implantations de telle sorte qu'on obtient pour le transistor à canal n et pour le transistor à canal p, une tension de service $|U_T|$ aussi symétrique que possible ;

p) dépôt et structuration de polysilicium pour la formation des zones de grille (22, 23, 40) ;

q) mise en œuvre d'un processus d'oxydation de telle sorte que la couche d'oxyde (31) ne masque pas les implantations ultérieures de source/drain (29, 38) des transistors à canal p et des transistors à canal n, mais puisse agir comme masque au voisinage de l'arête du polysilicium ;

r) dépôt d'un masque (36) constitué par une laque photosensible sur les régions (6, 18, 20, 22) des transistors à canal p, sur les transistors à canal n (10, 18, 21, 23) et sur les régions de source (34) ainsi que sur l'arête d'oxyde de champ des régions de drain (35) des transistors à canal n du type B ;

s) mise en œuvre d'une implantation (37) d'ions de phosphore dans la région de drain (35) de la région (21) des transistors à canal n ;

t) pénétration par diffusion des ions de phosphore (37) après dissolution du masque de laque photosensible (36) ;

u) mise en œuvre d'une autre implantation (38) d'ions de phosphore pour la production des régions .de source/drain (25, 26, 34, 35) des transistors à canal n du type A (25, 26) et du type B (34, 35) après masquage des régions (6) des cuvettes de type n avec une laque photosensible (24) ;

v) mise en œuvre d'une technique utilisant une laque photosensible pour réaliser le masquage (27) de la région des transistors à canal n ;

w) mise en œuvre d'une quatrième implantation (29) d'ions de bore pour la fabrication des régions de source/drain (30) des transistors à canal p ;

x) élimination du masque de laque photosensible (27), et

y) production, de façon connue, de la couche isolante, des régions des trous de contact et du plan des voies conductrices métalliques.

2. Procédé suivant la revendication 1, caractérisé par le fait que la dose et l'énergie de la première implantation (37) d'ions de phosphore lors de l'étape opératoire s) sont réglées à $5 \times 10^{13} - 1 \times 10^{15} \text{ cm}^{-2}$ et à 80 keV et que la dose et l'énergie de la seconde implantation (38) d'ions de phosphore lors de la phase opératoire u) sont réglées à $3 \times 10^{15} - 3 \times 10^{16} \text{ cm}^{-2}$ et à 80 keV.

3. Procédé suivant les revendications 1 et 2, caractérisé par le fait que la pénétration par diffusion des ions de phosphore lors de la phase opératoire t) est réalisée au voisinage de 1 000 °C pendant une durée de 1-5 heures.

4. Circuit intégré à transistors MOS présentant des fonctions numériques et analogiques et réalisé selon la technique VLSI, caractérisé par une diminution du dopage, qui est produite au moyen d'ions de phosphore implantés différemment, au niveau de la jonction pn des transistors analogiques, située du côté du drain, et qui diminue linéairement, selon une échelle logarithmique, depuis le bord du polysilicium constituant l'électrode de grille vers l'intérieur de la région du canal (figure 14).

FIG 1

FIG 2

FIG 3

FIG 4

## FIG 5

n  10  p  p⁻  2  p⁺  1  6  11  12

## FIG 6

13  12  11  13  12  13  n  10  p  p⁻  2  p⁺  6  1

## FIG 7

12  14  11  15  12  n  10  p  2  p⁻  p⁺  6  1

## FIG 8

12  6  16  17  11  12  17  12  16  n  p  10  p⁻  2  p⁺  1

## FIG 9

## FIG 10

## FIG 11

FIG 12

FIG 13

FIG 14